# EUROPEAN PATENT SPECIFICATION

(11) **EP 2 973 692 B1**
(45) Date of publication and mention of the grant of the patent: **03.05.2017**
(21) Application number: 14717606.9
(22) Date of filing: 13.03.2014
(51) Int. Cl.: H01L 23/498, H01L 23/66

(54) **MULTI-LAYER CORE ORGANIC PACKAGE SUBSTRATE AND ITS FABRICATION**
ORGANISCHES PACKUNGSSUBSTRAT MIT MEHRSCHICHTIGEM KERN UND DESSEN HERSTELLUNG
SUBSTRAT DE BOÎTIER ORGANIQUE À ÂME MULTICOUCHE ET SA FABRICATION

(30) Priority: 14.03.2013 US 201313827048
(43) Date of publication of application: 20.01.2016
(73) Proprietor: Xilinx, Inc., San Jose, California 95124 (US)
(72) Inventor: KIM, Namhoon, San Jose, CA 95124 (US); KIM, Joong-ho, San Jose, CA 95124 (US); RAMALINGAM, Suresh, San Jose, CA 95124 (US); WU, Paul, Y., San Jose, CA 95124 (US); KWON, Woon-seong, San Jose, CA 95124 (US); LEUNG, Dennis, C.P., San Jose, CA 95124 (US)
(74) Representative: Naismith, Robert Stewart
(86) International application number: PCT/US2014/026786
(87) International publication number: WO 2014/151993

(56) References cited:
- EP-A1- 1 713 313
- WO-A1-2012/043795

## Description

### FIELD

An embodiment described herein relates generally to package substrates and in particular to a multi-layer core organic package substrate.

### BACKGROUND

In fabricating an integrated circuit (IC) package, one or more integrated circuit (IC) dies may be placed on a package substrate to form an integrated circuit package. The package substrate serves to provide mechanical stability to the one or more integrated circuit (IC) dies as well as interconnections for the one or more integrated circuit (IC) dies. The package substrate may provide interconnectivity to input/output (I/O), power sources (e.g., supply power or ground), configuration information, etc. WO2012/043795 discloses a package substrate. One type of package substrate conventionally used in fabricating IC packages is a single-core organic package substrate. Single-core organic package substrates include a single organic core layer composed of an organic material and one or more build-up layers formed on top or below the single organic core layer. The one or more build-up layers provide interconnectivity for I/O, power, configuration information, etc. While single-core organic package substrates have several desirable characteristics for particular applications, such single-core organic package substrates include several deficiencies which may make them undesirable for integrated circuit (IC) dies that operate using high-speed signals (e.g., signal transmission rates greater than 16 gigabits per second (Gbps)). Some of these deficiencies include conductor loss and dielectric loss, which may lead to errors and undesirable performance of the IC package when operating at high speeds.

Another type of package substrate used for fabricating is a ceramic package substrate. Ceramic package substrates include several ceramic package layers formed using ceramic material that provide interconnectivity for I/O, power, configuration information, etc., for the one or more integrated circuit (IC) dies using the ceramic package substrate. Ceramic packages are preferred over single-core organic package substrates for high-speed applications because they have much more desirable loss characteristics in comparison to single-core organic package substrates. The dielectric loss and conductor loss associated with a ceramic package substrate is significantly less than that associated with the single-core organic package substrate and as such provides a better package substrate option for high-speed applications. However, costs associated with ceramic package substrates may be significantly greater than those associated with single-core organic package substrates. Additionally, significant noise associated with power distribution within ceramic package substrates may be present as well as cross-talk between ceramic package layers. Furthermore, the ceramic package substrates may have poor board level reliability, resulting in ceramic package substrates providing mechanical support for only a limited number of ceramic package layers.

### SUMMARY

A multi-layer core organic package substrate according to claim 1, and a method of making the same according to independent claim 8 are provided, with optional features as specified in the dependent claims.

Other and further aspects and features will be evident from reading the following detailed description.

### BRIEF DESCRIPTION OF THE DRAWINGS

The drawings illustrate the design and utility of various features described herein, in which similar elements are referred to by common reference numerals. These drawings are not necessarily drawn to scale. In order to better appreciate how the above-recited and other advantages and objects are obtained, a more particular description will be rendered, which are illustrated in the accompanying drawings. These drawings depict only exemplary features and are not therefore to be considered limiting in the scope of the claims.
FIG. 1 is a cross-sectional schematic diagram illustrating an integrated circuit (IC) package.
FIG. 2 is a cross-sectional schematic diagram illustrating a single-core organic package substrate.
FIG. 3 is a cross-sectional schematic diagram illustrating a ceramic package substrate.
FIG. 4 is a cross-sectional schematic diagram illustrating a multi-layer core organic package substrate.
FIG. 5 is a flow diagram illustrating a method for forming a multi-layer core organic package substrate.

### DETAILED DESCRIPTION

Various features are described hereinafter with reference to the figures. It should be noted that the figures are not drawn to scale and that the elements of similar structures or functions are represented by like reference numerals throughout the figures. It should be noted that the figures are only intended to facilitate the description of the features. They are not intended as an exhaustive description of the claimed invention or as a limitation on the scope of the claimed invention. In addition, an illustrated embodiment need not have all the aspects or advantages shown. An aspect or an advantage described in conjunction with a particular embodiment is not necessarily limited to that embodiment and can be practiced in any other embodiments even if not so illustrated.

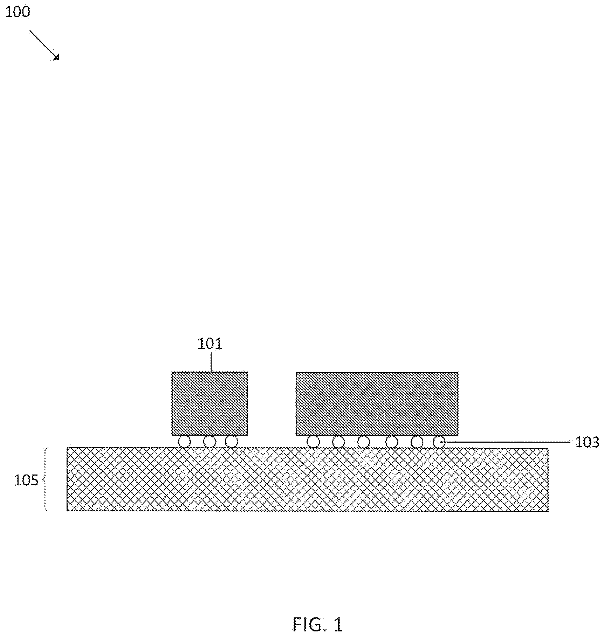

In fabricating an integrated circuit (IC) package, one or more integrated circuit (IC) dies may be placed on a package substrate to form an integrated circuit package. FIG. 1 is a cross-sectional schematic diagram illustrating an integrated circuit package 100.

The integrated circuit package may include one or more integrated circuit (IC) dies 101, a package substrate 105, and one or more microbumps 103 forming connections between the integrated circuit dies 101 and the package substrate 105. The integrated circuit die(s) 101 may perform different functionalities or may perform the same functionality. The package substrate 105 may be configured to support homogenous IC dies (e.g., IC dies that perform the same functionalities), heterogeneous IC dies (e.g., IC dies that perform different functionalities), or both.

The package substrate 105 serves to provide mechanical stability to the one or more integrated circuit (IC) dies 101 as well as interconnections for the one or more integrated circuit (IC) dies 101. The package substrate 105 may provide interconnectivity for input/output (I/O), power (e.g., supply power or ground), configuration information, etc. Interconnectivity for the one or more integrated circuit (IC) dies 101 may be provided through various metal layers (not shown) formed within the package substrate 105.

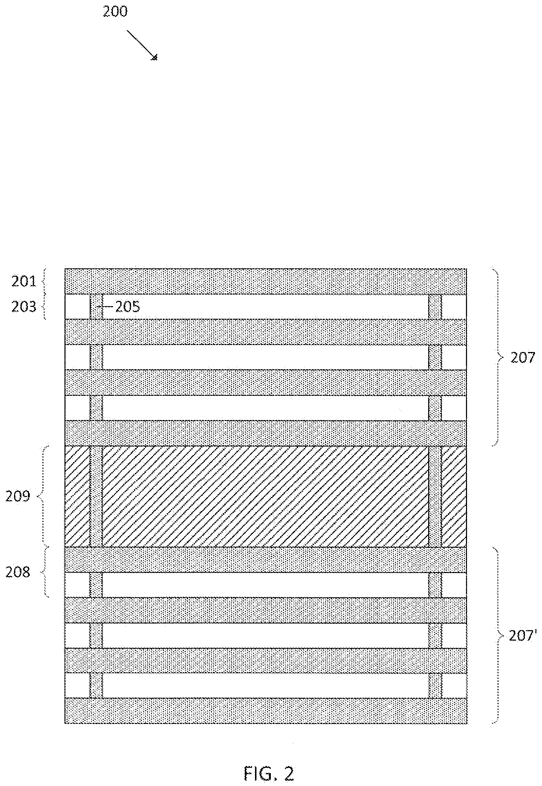

One type of package substrate that may be used in fabricating IC packages is a single-core organic package substrate. FIG. 2 is a cross-sectional schematic diagram illustrating a single-core organic package substrate 200. The single-core organic package substrate 200 includes a single organic core 209, a first plurality of build-up layers 207 formed on top of the single organic core 209, and a second plurality of build-up layers 207' formed below the single organic core 209.

Each build-up layer 208 of the plurality of build-up layers 207 includes a metal build-up layer 201 and a dielectric build-up layer 203. The metal build-up layers 201 of the respective build-up layers 208 may be connected through metal vias 205 formed in the dielectric build-up layers 203. Additionally, a bottom most metal build-up layer 201 of the first plurality build-up layers 207 may be connected to a top most metal build-up layer 201 of the second plurality of build-up layers 207' through metal vias 205 in the single organic core 209. The build-up layers 208 provide interconnectivity for IC dies connected to the single core organic package substrate 200 for I/O, power, configuration information, etc. Signals to and from IC dies connected to the single core organic package substrate 200 may be transmitted through the metal build-up layers 201 and metal vias 205 in the dielectric build-up layers 203.

While single-core organic package substrates 200 have several desirable characteristics for particular applications, such single-core organic package substrates include several deficiencies which may make them undesirable for integrated circuit (IC) dies that operate using high-speed signals (e.g., signal transmission rates greater than 16 gigabits per second (Gbps)). Some of these deficiencies include conductor loss and dielectric loss, which may lead to errors and undesirable performance of the IC package when operating at high speeds.

One way to reduce conductor loss and dielectric loss is to implement wider metal build-up layers 201 for each build-up layer 208 of the single-core organic package substrate 200. However, increasing metal build-up layer 201 thickness may lead to a lower impedance for the single core organic package substrate 200. The lower impedance attributed to increasing metal build-up layer 201 thickness cannot be compensated for by simply increasing dielectric build-up layer 203 thickness because of design constraints associated with the single core organic package substrate 200. Impedance matching is critical for package substrates because impedance mismatch can lead to severe reflection loss during the transmission of signals. Because increasing metal build-up layer 201 thickness to support high-speed signal transmission in single core organic package substrates 200 leads to impedance mismatch, single core organic package substrates 200 cannot support high speed signal transmission.

The single organic core 209 may support wider metal build-up layers 201 adjacent to the single organic core 209 because the organic core 209 has a greater thickness than the dielectric build-up layers 203. However with only a single organic core 209 signal density issues and high dielectric loss may still arise, making it undesirable to route high-speed signals through the metal build-up layers 201 adjacent to the single organic core 209 regardless of the metal build-up layer 201 thickness.

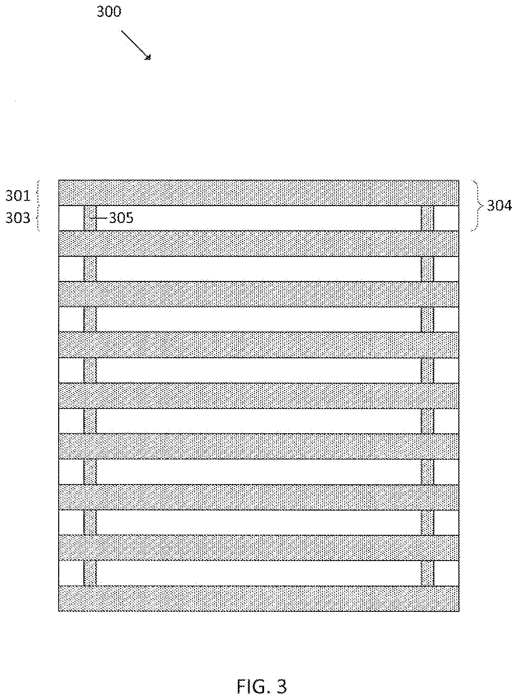

Another type of package substrate that may be used for fabricating IC packages is a ceramic package substrate. FIG. 3 is a cross-sectional schematic diagram illustrating a ceramic package substrate 300. The ceramic package substrate 300 includes a plurality of ceramic package layers 304 formed using ceramic material. Each of the plurality of ceramic package layers 304includes a metal ceramic package layer 301 and a dielectric ceramic package layer 303. The metal ceramic package layers 301 of the respective ceramic package layers 304 may be connected through metal vias 305 formed in the dielectric ceramic package layers 303.

The ceramic package layers 304 provide interconnectivity for IC dies connected to the ceramic package substrate 300 for I/O, power, configuration information, etc. Signals to and from IC dies connected to the ceramic package substrate 300 may be transmitted through the metal ceramic package layers 301 and metal vias 305.

Ceramic package substrates 300 may be preferred over single-core organic package substrates 200 for high-speed applications because they have much more desirable loss characteristics in comparison to single-core organic package substrates 200. The dielectric loss and conductor loss associated with a ceramic package substrate 300 may be significantly less than that associated with the single-core organic package substrate 200, and as such, may provide a better package substrate option for high-speed applications. However, costs associated with ceramic package substrates 300 may be significantly greater than those associated with single-core organic package substrates. Additionally, significant noise associated with power distribution within ceramic package substrates may be present as well as cross-talk between ceramic package layers 304, thereby reducing its ability to provide flexible high speed signal transmission to IC dies. Furthermore, the ceramic package substrates 300 may have poor board level reliability, resulting in ceramic packages providing mechanical support to only a limited number of ceramic package layers 304. Organic package substrates 200, on the other hand, exhibit desirable power distribution characteristics, insignificant cross-talk between build-up layers, and strong board level reliability, but cannot support high speed signal transmission due to its channel loss characteristics.

It would therefore be desirable to utilize the advantages of the single-core organic package substrate including its power distribution characteristics, insignificant cross-talk between build-up layers, and strong board-level reliability while minimizing conductor loss and dielectric loss such that high-speed signal transmission may be supported.

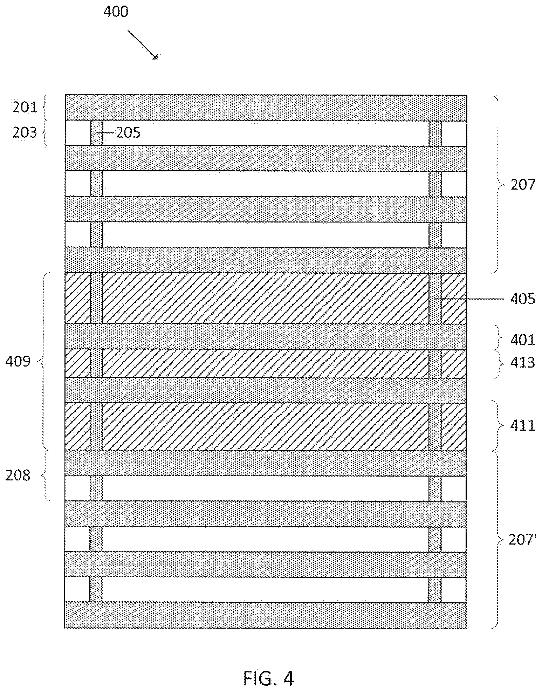

A multi-layer organic core package substrate provides the advantages of the single organic core package substrate while minimizing conductor loss and dielectric loss such that high-speed signal transmission may be supported. FIG. 4 is a cross-sectional schematic diagram illustrating a multi-layer organic core package substrate 400.

The multi-layer organic core organic package substrate 400 includes a multi-layer organic core 409, a first plurality of build-up layers 207 formed on top of the multi-layer organic core 409, and a second plurality of build-up layers 207' formed below the multi-layer organic core 409. The first plurality of build-up layers 207 or second plurality of build-up layers 207' may include (e.g., be formed using) an organic substrate.

The multi-layer organic core 409 includes multiple organic core layers 411, 413 separated by core metal layers 401. The multi-layer organic core 409 may include a center organic core layer 413 and one or more additional organic core layers 411. It should be noted that the center organic core layer 413 may or may not be located at the middle or center location in the multi-layer organic core 409. For example, in some cases, the center organic core layer 413 may be offset from the center location in the multi-layer organic core 409, as long as it is not located at the top-most or bottom-most layer. One additional organic core layer 411 may be formed on a top side of the center organic core layer 413. Another additional organic core layer 411 may be formed on a bottom side of the center organic core layer 413. The core metal layers 401 may be connected through metal vias 405 formed in the organic core layers 411, 413.

In some cases, at least one of the one or more additional organic core layers 411 may have a greater thickness than the center organic core layer 413. In other cases, at least one of the one or more additional organic core layers 411 may have a thickness less than or equal to the center organic core layer 413.

While FIG. 4 illustrates the multi-layer organic core 409 as having only three organic core layers 411, 413, it is important to note that the multi-layer organic core 409 may have any number of organic core layers 411, 413. For example, in some cases, the multi-layer organic core 409 may have at least ten organic core layers. Also, in other cases, the multi-layer organic core 409 may include only two organic core layers 411 separated by one core metal layer 401.

Each build-up layer 208 of the first plurality of build-up layers 207 includes a metal build-up layer 201 and a dielectric build-up layer 203. The metal build-up layers 201 of the respective build-up layers 208 may be connected through metal vias 205 in the dielectric build-up layers 203. A bottom most metal build-up layer 201 of the first plurality build-up layers 207 may be connected to a core metal layer 401 through a core metal via 405 formed within the organic core layer 411. Likewise, a top most metal build-up layer 201 of the second plurality of build-up layers 207 may be connected to a core metal layer 401 through a core metal via 405 within the organic core layer 411.

The build-up layers 208 and organic core layers 411, 413 provide interconnectivity for IC dies connected to the multi-layer core organic package substrate 400 for I/O, power, configuration information, etc. Signals to and from IC dies connected to the multi-layer core organic package substrate 400 may travel through the metal build-up layers 201, core metal layers 401, metal vias 205 and core metal vias 405. At least one (or each) of the core metal layers 401 separating the organic core layers 411, 413 has a greater thickness than a metal build-up layer 201. Increasing the thickness of the core metal layer(s) 401 reduces conductor loss and dielectric loss, such that the multi-layer organic core package substrate 400 can support high-speed signal transmission. The decrease in impedance associated with implementing thicker core metal layer(s) 401 can be compensated for by increasing the thickness of the additional organic core layer(s) 411. In some cases, at least one (or each) of the one or more organic core layers 411, 413 may have a greater thickness than a dielectric build-up layer 203. Increasing the thickness of the additional organic core layer(s) 411 allows for the multi-layer organic core package substrate 400 to be impedance-matched with incoming high-speed signals from integrated circuit dies connected to the multi-layer organic core package substrate 400. This allows for reduction (or minimization) of reflection loss that may occur during transmission of signals.

Additionally, having more organic core layers 411, 413 allows for additional routing paths for high speed signal transmission. Whereas the single organic core package substrate 200 only had two metal layers 201 adjacent to the single organic core layer 209, the multi-layer core organic package substrate 400 has multiple metal layers 401, 201 adjacent to organic core layers 411, 413. These adjacent metal layers 401, 201 may have greater thicknesses to support high-speed signal transmission while maintaining optimal impedance by configuring the organic core layer 411, 413 to have certain desired thicknesses.

In some cases, high-speed signals may be routed through the metal build-up layers 201 and core metal layers 401 adjacent to the organic core layers 411, 413 because signal density issues and high dielectric loss are minimized by the multi-layer organic core 409 configuration. This is in contrast to the single organic core 209 of FIG. 2, where signal density issues and high dielectric loss would make it undesirable to route high-speed signals through the metal build-up layers 201 adjacent to the single organic core 209.

In some cases, the multi-layer core organic package substrate 400 may support high-speed signal transmission rates at or above 28 gigabits per second (Gbps). In other cases, the multi-layer core organic package substrate may support signal transmission rates below 28 Gbps.

Thus, by implementing a multi-layer organic core package substrate 400, transmission of high-speed signals may be supported with minimal conductor loss and dielectric loss, while at the same time retaining the power distribution characteristics, insignificant cross-talk between build-up layers, and strong board-level reliability of the single-core organic package substrate 200 of FIG. 2.

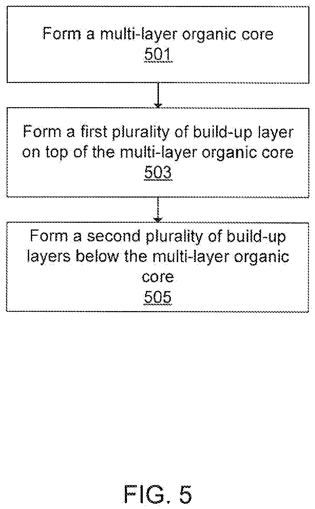

FIG. 5 is a flowchart illustrating a method for forming a multi-layer core organic package substrate. Initially, a multi-layer organic core is formed, as shown at item 501. As discussed above, with respect to FIG. 4, the multi-layer organic core includes multiple organic core layers separated by one or more core metal layers. In some cases, the multi-layer organic core may include a center organic core layer and one or more additional organic core layers on top of or below the center organic core layer. The multi-layer organic core may have any number (e.g., two or more) of organic core layers. The core metal layers may be connected through metal vias formed in the organic core layers.

In some cases, at least one of the one or more additional organic core layers may have a greater thickness than the center organic core layer. In other cases, at least one of the one or more additional organic core layers may have a thickness less than or equal to the center organic core layer.

Returning to FIG. 5, once the multi-layer organic core has been formed, a first plurality of build-up layers is formed on top of the multi-layer organic core as shown at item 503. The first plurality of build-up layers may include (e.g., be formed using) an organic substrate. Each build-up layer includes a metal build-up layer and a dielectric build-up layer. The metal build-up layers of each build-up layer may be connected through metal vias formed in the dielectric build-up layer.

Next, a second plurality of build-up layers may then be formed below the multi-layer organic core as shown at item 505. The second plurality of build-up layers may include (e.g., be formed using) an organic substrate. Each build-up layer includes a metal build-up layer and a dielectric build-up layer. The metal build-up layers of each build-up layer may be connected through metal vias formed in the dielectric build-up layer.

A bottom most metal build-up layer of the first plurality build-up layers may be connected to a core metal layer through a core metal via formed within the organic core layer. Likewise, a top most metal build-up layer of the second plurality of build-up layers may be connected to a core metal layer through a core metal via within the organic core layer.

The build-up layers and organic core layers provide interconnectivity for IC dies connected to the multi-layer core organic package substrate for I/O, power, configuration information, etc. Signals to and from IC dies connected to the multi-layer core organic package substrate may be transmitted through the metal build-up layers, core metal layers, metal vias and core metal vias.

As mentioned above, in some cases, the core metal layer(s) separating the organic core layers may have a greater thickness than the metal build-up layers. Increasing the core metal layer(s) thickness reduces conductor loss and dielectric loss, such that the multi-layer organic core package substrate can support high-speed signal transmission. The decrease in impedance associated with implementing thicker core metal layer(s) may be compensated for by increasing the thickness of the additional organic core layer(s). In some cases, at least one of the one or more organic core layers may have a greater thickness than a dielectric build-up layer. Increasing the thickness of the additional organic core layer(s) allows for the multi-layer organic core package substrate to be impedance-matched with incoming high-speed signals from integrated circuit dies connected to the multi-layer organic core package substrate. This may allow for a reduction or minimization of reflection loss that occurs during the transmission of signals.

In some cases, high-speed signals may be routed through the metal build-up layers and core metal layers adjacent to the organic core layers because signal density issues and high dielectric loss may be reduced or minimized by the multi-layer organic core configuration. This is in contrast to the single organic core, where signal density issues and high dielectric loss would make it undesirable to route high-speed signals through the metal build-up layers adjacent to the single organic core.

Thus, by implementing a multi-layer organic core package substrate 400, transmission of high-speed signals may be supported with minimal conductor loss and dielectric loss, while at the same time retaining the power distribution characteristics, insignificant cross-talk between build-up layers, and strong board-level reliability of the single-core organic package substrate.

It should be noted that the term "on top", as used in this specification, may refer to directly on top, or indirectly on top. For example, when the first plurality of build-up layers is described as being formed "on top" of the multi-layer organic core, the first plurality of build-up layers may be either directly on top (e.g., abutting) of the multi-layer organic core, or indirectly on top of the multi-layer organic core (e.g., the first plurality of build-up layers may be on another layer that is between the first plurality of build-up layers and the multi-layer organic core).

Likewise, it should be noted that the term "below", as used in this specification, may refer to directly below, or indirectly below. For example, when the second plurality of build-up layers is described as being formed "below" the multi-layer organic core, the second plurality of build-up layers may be either directly below (e.g., abutting) the multi-layer organic core, or indirectly below the multi-layer organic core (e.g., the second plurality of build-up layers may be on another layer that is between the second plurality of build-up layers and the multi-layer organic core). Note also that "on top" and "below" are relative terms, and that this specification contemplates various orientations and is broad enough to encompass such orientations.

Also, as used in this specification, the term "plurality" may refer to two or more items. For example, a "plurality" of build-up layers may refer to two or more build-up layers, which may or may not be all of the available build-up layers. Accordingly, the phrase "each" build-up layer may refer to each of two or more build-up layers, which may or may not be all of the available build-up layers.

## Claims

1. A multi-layer core organic package substrate (400), comprising:
a multi-layer core (409) comprising at least three organic core layers (411, 413) comprising a center organic core layer (413) between a top organic core layer (413) and a bottom organic core layer, the center organic core layer (413) separated from the top organic core layer (411) by a top core metal layer (401) and separated from the bottom organic core layer by a bottom core metal layer (401), the center organic core layer (413), the top organic core layer, and the bottom organic core layer including metal vias (405) to electrically couple the top metal layer and the bottom metal layer;
a first plurality of build-up layers (207) formed on top of the multi-core layer (409); and
a second plurality of build-up layers (207') formed below the multi-core layer (409);
wherein at least one of (1) the first plurality of build-up layers (207) and (2) the second plurality of build-up layers (207') comprises a metal build-up layer (201) and a dielectric build-up layer (203); and
wherein at least one of the top core metal layer (401) or the bottom core metal layer has a greater thickness than a thickness of the metal build-up layer (201).

2. The multi-layer core organic package (400) substrate of claim 1, wherein the top organic core layer (411) and the bottom organic core layer (411) each has a thickness to support high-speed signal transmission.

3. The multi-layer core organic package substrate of claim 1 or claim 2, wherein the at least one of the top organic core layer (411) or the bottom organic core layer (411) has a greater thickness than a thickness of the center organic core layer (413).

4. The multi-layer core organic package substrate of claim 1, wherein at least one of the top organic core layer (411) or the bottom organic core layer (411) has a greater thickness than the dielectric build-up layer (203).

5. The multi-layer core organic package substrate of any of claims 1-4, wherein at least one of (1) the first plurality of build-up layers (207) and (2) the second plurality of build-up layers (207') is configured to be impedance-matched with incoming high-speed signals.

6. The multi-layer core organic package substrate (400) of any of claims 1-5, wherein at least one of the first plurality of build-up layers (207), the second plurality of build-up layers (207'), and the multi-layer organic core (400), is configured to provide one of I/O, power, ground, and configuration interconnectivity.

7. The multi-layer core organic package substrate (400) of any of claims 1-6, wherein at least one of (1) the first plurality of build-up layers and (2) the second plurality of build-up layers includes an organic substrate (400).

8. A method for forming a multi-layer core organic package substrate according to claim 1, said method comprising:
forming a multi-layer organic core comprising at least three organic core layers comprising a center organic core layer between a top organic core layer and a bottom organic core layer, the center organic core layer separated from the top organic core layer by a top core metal layer and separated from the bottom organic core layer by a bottom core metal layer, the center organic core layer, the top organic core layer, and the bottom organic core layer including metal vias to electrically couple the top metal layer and the bottom metal layer;
forming a first plurality of build-up layers on top of the multi-core layer; and
forming a second plurality of build-up layers below the multi-core layer;
wherein at least one of (1) the first plurality of build-up layers and (2) the second plurality of build-up layers comprises a metal build-up layer and a dielectric build-up layer; and
wherein at least one of the top core metal layer or the bottom core metal layer has a greater thickness than a thickness of the metal build-up layer.

## Patentansprüche

1. Organisches Packungssubstrat mit mehrschichtigem Kern (400), umfassend:
einen mehrschichtigen Kern (409), umfassend mindestens drei organische Kernschichten (411, 413), umfassend eine mittige organische Kernschicht (413) zwischen einer oberen organischen Kernschicht (413) und einer unteren organischen Kernschicht, wobei die mittige organische Kernschicht (413) von der oberen organischen Kernschicht (411) durch eine obere Kernmetallschicht (401) getrennt ist und von der unteren organischen Kernschicht durch eine untere Kernmetallschicht (401) getrennt ist, wobei die mittige organische Kernschicht (413), die obere organische Kernschicht und die untere organische Kernschicht Metalldurchkontaktierungen (405) zum elektrischen Verbinden der oberen Metallschicht und der unteren Metallschicht umfassen;
eine erste Mehrzahl von Aufbauschichen (207), die über der Mehrkernschicht (409) gebildet sind;
eine zweite Mehrzahl von Aufbauschichen (207'), die unter der Mehrkernschicht (409) gebildet sind;
wobei mindestens eine von (1) der ersten Mehrzahl von Aufbauschichten (207) und (2) der zweiten Mehrzahl von Aufbauschichten (207') eine Metallaufbauschicht (201) und eine dielektrische Aufbauschicht (203) umfasst; und
wobei mindestens eine der oberen Kernmetallschicht (401) oder der unteren Kernmetallschicht eine größere Dicke als eine Dicke der Metallaufbauschicht (201) aufweist.

2. Organisches Packungssubstrat mit mehrschichtigem Kern (400) nach Anspruch 1, wobei die obere organische Kernschicht (411) und die untere organische Kernschicht (411) jeweils eine Dicke zum Unterstützen von Hochgeschwindigkeitssignalübertragung aufweist.

3. Organisches Packungssubstrat mit mehrschichtigem Kern nach Anspruch 1 oder Anspruch 2, wobei die mindestens eine von der oberen organischen Kernschicht (411) oder der unteren organischen Kernschicht (411) eine größere Dicke als eine Dicke der mittigen organischen Kernschicht (413) aufweist.

4. Organisches Packungssubstrat mit mehrschichtigem Kern nach Anspruch 1, wobei mindestens eine von der oberen organischen Kernschicht (411) oder der unteren organischen Kernschicht (411) eine größere Dicke als die dielektrische Aufbauschicht (203) aufweist.

5. Organisches Packungssubstrat mit mehrschichtigem Kern nach einem der Ansprüche 1-4, wobei mindestens eine von (1) der ersten Mehrzahl von Aufbauschichten (207) und (2) der zweiten Mehrzahl von Aufbauschichten (207') konfiguriert ist, um an die ankommenden Hochgeschwindigkeitssignale impedanzangepasst zu sein.

6. Organisches Packungssubstrat mit mehrschichtigem Kern (400) nach einem der Ansprüche 1-5, wobei mindestens eine von der ersten Mehrzahl von Aufbauschichten (207), der zweiten Mehrzahl von Aufbauschichten (207') und dem mehrschichtigen organische Kern (400) konfiguriert ist, um eine von E/A-, Energie-, Erdungs- und Konfigurationsinterkonnektivität bereitzustellen.

7. Organisches Packungssubstrat mit mehrschichtigem Kern (400) nach einem der Ansprüche 1-6, wobei mindestens eine von (1) der ersten Mehrzahl von Aufbauschichten und (2) der zweiten Mehrzahl von Aufbauschichten ein organisches Substrat (400) umfasst.

8. Verfahren zum Bilden eines organisches Packungssubstrat mit mehrschichtigem Kern nach Anspruch 1, wobei das Verfahren Folgendes umfasst:
das Bilden eines mehrschichtigen organischen Kerns, umfassend mindestens drei organische Kernschichten, umfassend eine mittige organische Kernschicht zwischen einer oberen organischen Kernschicht und einer unteren organischen Kernschicht, wobei die mittige organische Kernschicht von der oberen organischen Kernschicht durch eine obere Kernmetallschicht getrennt ist und von der unteren organischen Kernschicht durch eine untere Kernmetallschicht getrennt ist, wobei die mittige organische Kernschicht, die obere organische Kernschicht und die untere organische Kernschicht Metalldurchkontaktierungen zum elektrischen Verbinden der oberen Metallschicht und der unteren Metallschicht umfassen;
das Bilden einer ersten Mehrzahl von Aufbauschichen über der Mehrkernschicht; und
das Bilden einer zweiten Mehrzahl von Aufbauschichen unter der Mehrkernschicht;
wobei mindestens eine von (1) der ersten Mehrzahl von Aufbauschichten und (2) der zweiten Mehrzahl von Aufbauschichten eine Metallaufbauschicht und eine dielekrische Aufbauschicht umfasst; und
wobei mindestens eine der oberen Kernmetallschicht oder der unteren Kernmetallschicht eine größere Dicke als eine Dicke der Metallaufbauschicht aufweist.

## Revendications

1. Substrat de boîtier organique à âme multicouche (400), comprenant :
un âme multicouche (409) comprenant au moins trois couches d'âme organique (411, 413) comprenant une couche d'âme organique centrale (413) entre une couche d'âme organique supérieure (413) et une couche d'âme organique inférieure, la couche d'âme organique centrale (413) étant séparée de la couche d'âme organique supérieure (411) par une couche de métal d'âme supérieure (401) et étant séparée de la couche d'âme organique inférieure par une couche de métal d'âme inférieure (401), la couche d'âme organique centrale (413), la couche d'âme organique supérieure, et la couche d'âme organique inférieure comprenant des vias métalliques (405) afin de coupler électriquement la couche de métal supérieure et la couche de métal inférieure ;
une première pluralité de couches d'accumulation (207) formées sur le dessus de la couche multi-âme (409) ; et
une deuxième pluralité de couches d'accumulation (207') formées en dessous de la couche multi-âme (409) ;
dans lequel au moins une parmi (1) la première pluralité de couches d'accumulation (207) et (2) la deuxième pluralité de couches d'accumulation (207') comprend une couche d'accumulation en métal (201) et une couche d'accumulation en matériau diélectrique (203) ; et
dans lequel au moins une parmi la couche de métal d'âme supérieure (401) ou la couche de métal d'âme inférieure présente une épaisseur supérieure à une épaisseur de la couche d'accumulation en métal (201).

2. Substrat de boîtier organique à âme multicouche (400) selon la revendication 1, dans lequel la couche d'âme organique supérieure (411) et la couche d'âme organique inférieure (411) présentent respectivement une épaisseur destinée à supporter une transmission de signal haute vitesse.

3. Substrat de boîtier organique à âme multicouche selon la revendication 1 ou 2, dans lequel la au moins une parmi la couche d'âme organique supérieure (411) ou la couche d'âme organique inférieure (411) présente une épaisseur supérieure à une épaisseur de la couche d'âme organique centrale (413).

4. Substrat de boîtier organique à âme multicouche selon la revendication 1, dans lequel au moins une parmi la couche d'âme organique supérieure (411) ou la couche d'âme organique inférieure (411) présente une épaisseur supérieure à une épaisseur de la couche d'accumulation en matériau diélectrique (203).

5. Substrat de boîtier organique à âme multicouche selon l'une quelconque des revendications 1 à 4, dans lequel au moins une parmi (1) la première pluralité de couches d'accumulation (207) et (2) la deuxième pluralité de couches d'accumulation (207') est configurée pour que son impédance soit adaptée à des signaux haute vitesse entrants.

6. Substrat de boîtier organique à âme multicouche (400) selon l'une quelconque des revendications 1 à 5, dans lequel au moins une parmi la première pluralité de couches d'accumulation (207), la deuxième pluralité de couches d'accumulation (207'), et le âme organique multicouche (400) est configuré(e) pour fournir une parmi une interconnectivité d'entrée/sortie, de mise sous tension, de mise à la terre, et de configuration.

7. Substrat de boîtier organique à âme multicouche (400) selon l'une quelconque des revendications 1 à 6, dans lequel au moins une parmi (1) la première pluralité de couches d'accumulation et (2) la deuxième pluralité de couches d'accumulation comprend un substrat organique (400).

8. Procédé permettant de former un substrat de boîtier organique à âme multicouche selon la revendication 1, ledit procédé comprenant les étapes consistant à :
former un âme organique multicouche comprenant au moins trois couches d'âme organique comprenant une couche d'âme organique centrale entre une couche d'âme organique supérieure et une couche d'âme organique inférieure, la couche d'âme organique centrale étant séparée de la couche d'âme organique supérieure par une couche de métal d'âme supérieure et étant séparée de la couche d'âme organique inférieure par une couche de métal d'âme inférieure, la couche d'âme organique centrale, la couche d'âme organique supérieure, et la couche d'âme organique inférieure comprenant des vias métalliques destinés à coupler électriquement la couche de métal supérieure et la couche de métal inférieure ;
former une première pluralité de couches d'accumulation sur le dessus de la couche multi-âme ; et
former une deuxième pluralité de couches d'accumulation en dessous de la couche multi-âme ;
dans lequel au moins une parmi (1) la première pluralité de couches d'accumulation et (2) la deuxième pluralité de couches d'accumulation comprend une couche d'accumulation en métal et une couche d'accumulation en matériau diélectrique ; et
dans lequel au moins une parmi la couche de métal d'âme supérieure ou la couche de métal d'âme inférieure présente une épaisseur supérieure à une épaisseur de la couche d'accumulation en métal.
